# EUROPEAN PATENT APPLICATION

(11) **EP 4 646 037 A1**
(43) Date of publication of application: **05.11.2025**
(21) Application number: 23912709.5
(22) Date of filing: 15.12.2023
(51) Int. Cl.: H05K 1/02, H05K 1/14, H01L 23/498, G02F 1/1333

(54) **FLEXIBLE CIRCUIT BOARD, COF MODULE, AND ELECTRONIC DEVICE INCLUDING SAME**

(30) Priority: 30.12.2022 KR 20220190821
(71) Applicant: LG Innotek Co., Ltd., Seoul 07796 (KR)
(72) Inventor: CHAE, Sung Min, Seoul 07796 (KR); PARK, Ji Hyo, Seoul 07796 (KR); YOON, Hyung Kyu, Seoul 07796 (KR)
(74) Representative: M. Zardi & Co S.A.
(86) International application number: PCT/KR2023/020808
(87) International publication number: WO 2024/144034

(57) **Abstract**

A flexible circuit board according to an embodiment includes a substrate including a first surface and a second surface opposite to the first surface; a first circuit pattern and a second circuit pattern disposed on the first surface; and a metal pattern disposed on the second surface, wherein the second surface includes a plurality of first regions and a plurality of second regions, wherein a first pattern is disposed on the first region, wherein a second pattern is disposed on the second region, and wherein an area of the second pattern is larger than an area of the first pattern.

## Description

### [Technical Field]

An embodiment relates to a flexible circuit board, a COF module and an electronic device including the same.

### [Background Art]

Recently, various electronic products are becoming thinner and smaller. Accordingly, it is required to mount semiconductor chips in a narrow region of the electronic product at a high density.

COF (Chip On Film) includes a flexible circuit board. Accordingly, the COF is applied to a flexible display. In addition, a COF method can implement a fine pitch, and accordingly, the COF is applied to a high-resolution display.

The COF is formed by mounting a semiconductor chip on a thin flexible circuit board. The semiconductor chip may include an integrated circuit (IC) chip or a large scale integrated circuit (LSI) chip.

The chip is connected to an external circuit board and a display panel through a circuit pattern. For example, pad parts are disposed at one end and other end of the circuit pattern. One pad part is electrically connected to a terminal of the chip. The other pad part is connected to the circuit board and a terminal of the display panel. Accordingly, the chip, the circuit board, and the display panel are electrically connected through the COF. Accordingly, a signal of the chip is transmitted to the display panel through the circuit pattern.

The flexible circuit board includes a plurality of circuit patterns. The circuit patterns are connected to the chip, the circuit board, and the display panel. A chip is mounted on the flexible circuit board. The signal is transmitted to the chip, the circuit board, and the display panel through the circuit pattern. Then, the flexible circuit board is cut along a cutting line. Accordingly, a COF module is manufactured.

The chip generates heat during operation. Accordingly, an internal temperature of the COF module may increase. Accordingly, reliability of the COF module may decrease.

Therefore, a flexible circuit board having a new structure capable of solving the above problems, a COF module, and an electronic device including the same are required.

### [Disclosure]

### [Technical Problem]

The embodiment provides a flexible circuit board capable of preventing warping.

The embodiment provides a flexible circuit board having improved heat dissipation effect.

### [Technical Solution]

A flexible circuit board according to an embodiment comprises a substrate including a first surface and a second surface opposite to the first surface; a first circuit pattern and a second circuit pattern disposed on the first surface; and a metal pattern disposed on the second surface, wherein the second surface includes a plurality of first regions and a plurality of second regions, wherein a first pattern is disposed on the first region, wherein a second pattern is disposed on the second region, and wherein an area of the second pattern is larger than an area of the first pattern.

### [Advantageous Effects]

A flexible circuit board according to an embodiment includes a first surface and a second surface opposite to the first surface. A chip is disposed on the first surface.

The flexible circuit board includes a metal pattern. The metal pattern is disposed on the first surface and the second surface. Therefore, heat generated from the chip is dissipated to an outside through the metal pattern. Therefore, an increase in an internal temperature of the COF module is prevented.

The metal pattern has a set width. Accordingly, an increase in stress due to the metal pattern is prevented. Therefore, the flexible circuit board is prevented from bending. That is, warpage of the flexible circuit board is reduced.

Therefore, the flexible circuit board according to the embodiment has improved heat dissipation characteristics and reliability.

A flexible circuit board according to another embodiment includes a plurality of regions. Patterns having different areas are disposed in the plurality of regions, respectively. Therefore, a heat dissipation effect is improved by a pattern having a large area. In addition, the flexible circuit board is prevented from bending by a pattern having a small area. Specifically, the stress is prevented from increasing by the pattern having a small area. Therefore, the warpage of the flexible circuit board is reduced.

Therefore, the flexible circuit board according to another embodiment has improved heat dissipation characteristics and reliability.

### [Description of Drawings]

FIG. 1 is a top view of a flexible circuit board according to an embodiment.
FIG. 2 is a bottom view of a flexible circuit board according to a first embodiment.
FIGS. 3 and 4 are enlarged views of region A of FIG. 2.
FIG. 5 is an enlarged view of region B of FIG. 2.
FIG. 6 is an enlarged view of region C of FIG. 2.
FIG. 7 is a bottom view of a flexible circuit board according to a second embodiment.
FIG. 8 is an enlarged view of region D of FIG. 7.
FIG. 9 is an enlarged view of region E of FIG. 2.
FIG. 10 is another bottom view of a flexible circuit board according to a second embodiment.
FIG. 11 is an enlarged view of region F of FIG. 10.
FIG. 12 is an enlarged view of region G of FIG. 10.
FIGS. 13 and 14 are cross-sectional views taken along region A-A' of FIG. 1.
FIG. 15 is a diagram for describing a COF module according to an embodiment.
FIGS. 16 to 18 are diagrams of an electronic device including a flexible circuit board according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

In addition, in a following description, a first direction 1D may be defined in a longitudinal direction of the flexible circuit board, and a second direction 2D may be defined in a width direction of the flexible circuit board.

Hereinafter, a flexible circuit board, a COF module, and an electronic device including the same according to an embodiment will be described with reference to the drawings.

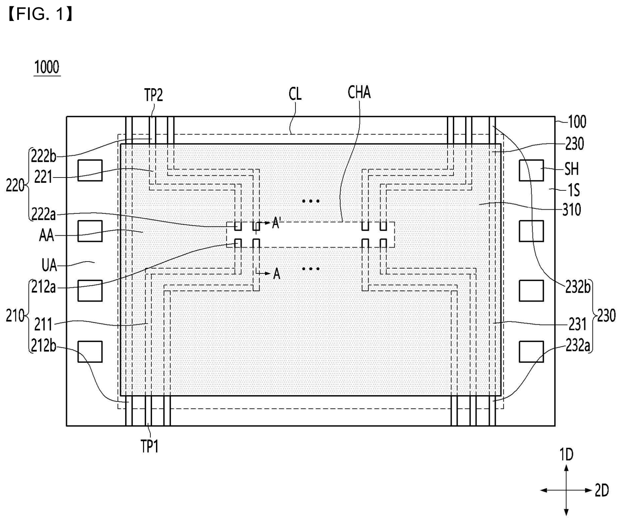

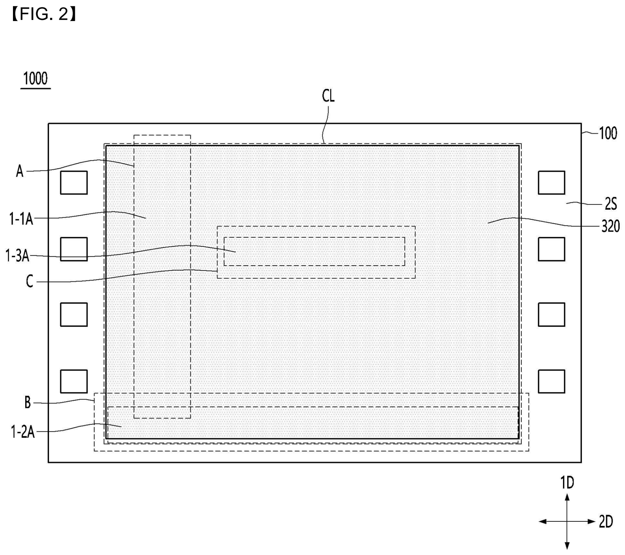

Referring to FIGS. 1 and 2, the flexible circuit board 1000 includes a substrate 100, a circuit pattern, a protective layer, and a metal pattern.

The substrate 100 includes a first surface 1S and a second surface 2S. The first surface 1S and the second surface 2S are opposite surfaces. The circuit pattern, the metal pattern, and the protective layer are disposed on the first surface 1S and the second surface 2S.

The substrate 100 includes a cutting line CL. The flexible circuit board 1000 is cut along the cutting line CL. In detail, the circuit pattern, the metal pattern, the protective layer, and the chip are disposed on the substrate 100. Then, the substrate 100 is cut along the cutting line CL. Accordingly, the COF module 2000 is manufactured.

The substrate 100 includes an active region AA and an unactive region UA. In detail, the first surface 1S includes the active region AA and the unactive region UA.

The active region AA and the unactive region UA are separated by the cutting line CL. In detail, the active region AA is an inner region of the cutting line CL. The unactive region UA is an outer region of the cutting line CL.

The circuit pattern, the protective layer, and the chip are disposed on the active region AA. A dummy pattern and a sprocket hole SH are disposed on the unactive region UA. The dummy pattern increases a strength of the substrate 100. The flexible circuit board 1000 is rolled or unrolled in a roll-to-roll manner by the sprocket hole SH.

The substrate 100 includes a chip mounting region CHA. The chip mounting region CHA is disposed on the first surface 1S. The chip mounting region CHA is disposed on the active region AA. The chip is disposed on the chip mounting region CHA. Pad parts of the circuit pattern are disposed inside the chip mounting region CHA. The protective layer is not disposed on the chip mounting region CHA.

The substrate 100 includes a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the flexible circuit board is applied to various electronic devices including a curved display device.

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, a thickness of the flexible circuit board increases. Accordingly, the flexible characteristic of the flexible circuit board decreases. If the thickness of the substrate 100 is less than 20 µm, the strength of the substrate decreases. Accordingly, the substrate may be damaged by heat and pressure generated when the chip is mounted.

The circuit pattern and the protective layer are disposed on the substrate 100. In detail, the circuit pattern and the protective layer are disposed on the first surface 1S. In detail, the circuit pattern and the protective layer are disposed on the active region AA and the unactive region UA.

The circuit pattern includes a first circuit pattern 210, a second circuit pattern 220, and a third circuit pattern 230.

Referring to FIG. 1, the first circuit pattern 210 includes a first wiring part 211, a first pad part 212a, and a second pad part 212b. The first wiring part 211, the first pad part 212a, and the second pad part 212b may include a same material. The first wiring part 211, the first pad part 212a, and the second pad part 212b may be formed integrally.

The first pad part 212a is disposed inside the chip mounting region CHA. Accordingly, the first pad part 212a is connected to a terminal of the chip. By this, the first circuit pattern 210 and the chip are connected.

The second pad part 212b is disposed outside the chip mounting region CHA. The second pad part 212b is connected to a terminal of an external circuit board. By this, the first circuit pattern 210 and the circuit board are connected.

The first wiring part 211 is disposed between the first pad part 212a and the second pad part 212b. The first wiring part 211 connects the first pad part 212a and the second pad part 212b. Accordingly, the chip and the circuit board are connected. Therefore, a signal generated by the chip is transmitted to the circuit board.

The first circuit pattern 210 may further include a test pad part. In detail, a first test pad part TP1 is disposed on the unactive region UA. The first wiring part 211, the first pad part 212a, the second pad part 212b, and the first test pad part TP1 may be formed integrally.

Before connecting the circuit board and the second pad part 212b, the first circuit pattern 210 may be tested. For example, it is possible to check whether the first circuit pattern is open or shorted through the first test pad part TP1.

The second circuit pattern 220 includes a second wiring part 221, a third pad part 222a, and a fourth pad part 222b. The second wiring part 221, the third pad part 222a, and the fourth pad part 222b may include a same material. In addition, the second wiring part 221, the third pad part 222a, and the fourth pad part 222b may be formed integrally.

The third pad part 222a is disposed inside the chip mounting region CHA. Accordingly, the third pad part 222a is connected to a terminal of the chip. Accordingly, the second circuit pattern 220 and the chip are connected.

The fourth pad part 222b is disposed outside the chip mounting region CHA. The fourth pad part 222b is connected to a terminal of an external display panel. Accordingly, the second circuit pattern 220 and the display panel are connected.

The second wiring part 221 is disposed between the third pad part 222a and the fourth pad part 222b. The second wiring part 221 connects the third pad part 222a and the fourth pad part 222b. Accordingly, the chip and the display panel are connected. Accordingly, a signal generated from the chip moves to the display panel.

The second circuit pattern 220 may further include a test pad part. In detail, a second test pad part TP2 is disposed on the unactive region UA. The second wiring part 221, the third pad part 222a, the fourth pad part 222b, and the second test pad part TP2 may be formed integrally.

Before connecting the display panel and the fourth pad part 222b, the second circuit pattern 220 can be tested. For example, it is possible to check whether the second circuit pattern is open or shorted through the second test pad part TP2.

The third circuit pattern 230 includes a third wiring part 231, a fifth pad part 232a, and a sixth pad part 232b. The third wiring part 231, the fifth pad part 232a, and the sixth pad part 232b may include a same material. In addition, the third wiring part 231, the fifth pad part 232a, and the sixth pad part 232b may be formed integrally.

The fifth pad part 232a and the sixth pad part 232b are disposed outside the chip mounting region CHA. The fifth pad part 232a is connected to a terminal of an external circuit board. In addition, the sixth pad part 232b is connected to a terminal of an external display panel.

The third wiring part 231 is disposed between the fifth pad part 232a and the sixth pad part 232b. The third wiring part 231 connects the fifth pad part 232a and the sixth pad part 232b. Accordingly, the circuit board and the display panel are connected.

A first protective layer 310 is disposed on the first surface 1S. Accordingly, the first protective layer 310 is disposed on the first circuit pattern 210, the second circuit pattern 220, and the third circuit pattern 230. The first protective layer 310 is not disposed on the first pad part 212a, the second pad part 212b, the third pad part 222a, the fourth pad part 222b, the fifth pad part 232a, and the sixth pad part 232b.

A chip is disposed on the chip mounting region CHA. The chip generates heat during operation. As a result, an internal temperature of the COF module 2000 may increase. Accordingly, the flexible circuit board according to the embodiment includes a metal pattern.

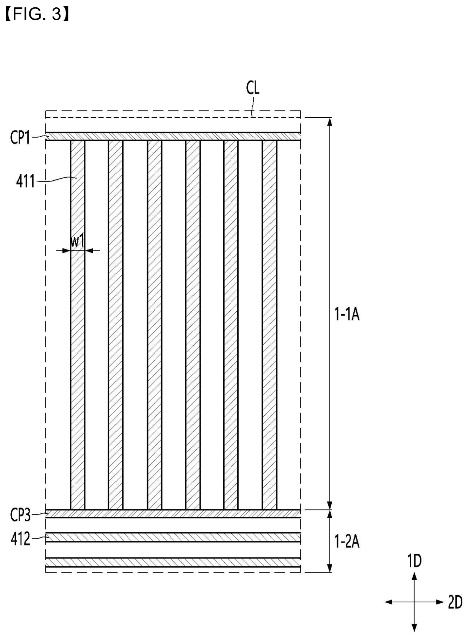

A flexible circuit board according to a first embodiment will be described with reference to FIGS. 2 to 6. In FIGS. 3 to 6, the second protective layer is omitted for convenience of explanation.

Referring to FIGS. 2 to 6, the metal pattern is disposed on the substrate 100. In detail, the metal pattern is disposed on the second surface 2S. The metal pattern is not connected to the chip. The metal pattern may include a first-first pattern 411 and a first-second pattern 412.

Referring to FIG. 2, the second surface 2S includes a plurality of regions. For example, the second surface 2S may include a first-first region 1-1A, a first-second region 1-2A, and a first-third region 1-3A.

The first-first region 1-1A and the first-second region 1-2A do not correspond to the chip mounting region CHA. The first-third region 1-3A corresponds to the chip mounting region CHA.

The first-second region 1-2A corresponds to a region where the fourth pad part 222b is disposed on the first surface 1S.

Metal patterns are disposed in the first-first region 1-1A, the first-second region 1-2A, and the first-third region 1-3A, respectively. The first-first pattern 411 and the first-second pattern 412 are disposed in the first-first region 1-1A, the first-second region 1-2A, and the first-third region 1-3A. The first-first pattern 411 extends in the first direction 1D. That is, a longitudinal direction of the first-first pattern 411 is the first direction 1D. In addition, the first-second pattern 412 extends in the second direction 2D. That is, a longitudinal direction of the first-second pattern 412 is the second direction 2D.

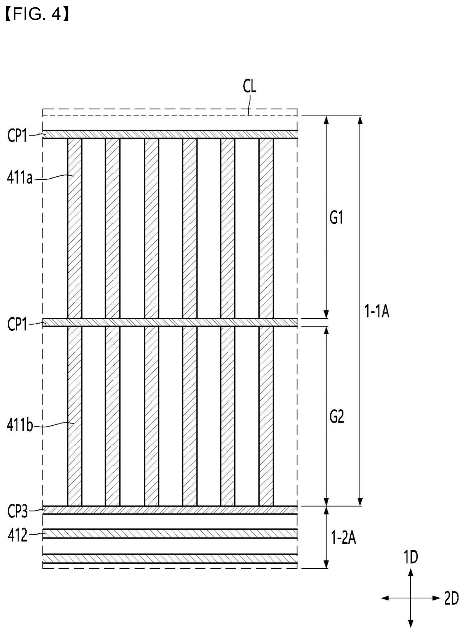

Referring to FIG. 3 and FIG. 4, the first-first pattern 411 is disposed on the first-first region 1-1A. In detail, a plurality of first-first patterns 411 are disposed on the first-first region 1-1A. The plurality of first-first patterns 411 are spaced apart in the second direction 2D.

The first-first pattern 411 is formed with a set width. For example, a width w1 of the first-first pattern 411 may be 20 µm or less. For example, the width w1 of the first-first pattern 411 may be 5 µm to 20 µm, 6 µm to 15 µm, or 7 µm to 12 µm. Therefore, a pattern having a fine line width is disposed on the first-first region 1-1A.

A first connection pattern CP1 is disposed on the first-first region 1-1A. The first connection pattern CP1 is connected to a plurality of first-first patterns 411. In detail, the first connection pattern CP1 is connected to the plurality of first-first patterns 411 spaced apart in the second direction 2D. Therefore, the plurality of first-first patterns 411 are connected by the first connection pattern CP1.

Referring to FIG. 4, the first-first pattern 410 includes a plurality of groups. For example, the first-first pattern 411 may include a first group G1 and a second group G2. The first group G1 includes a first-first-a pattern 411a. The second group G2 includes a first-first-b pattern 411b.

The first group G1 and the second group G2 are spaced apart. In addition, the first connection pattern CP1 is disposed between the first group G1 and the second group G2. Therefore, the first group G1 and the second group G2 are connected by the first connection pattern CP1.

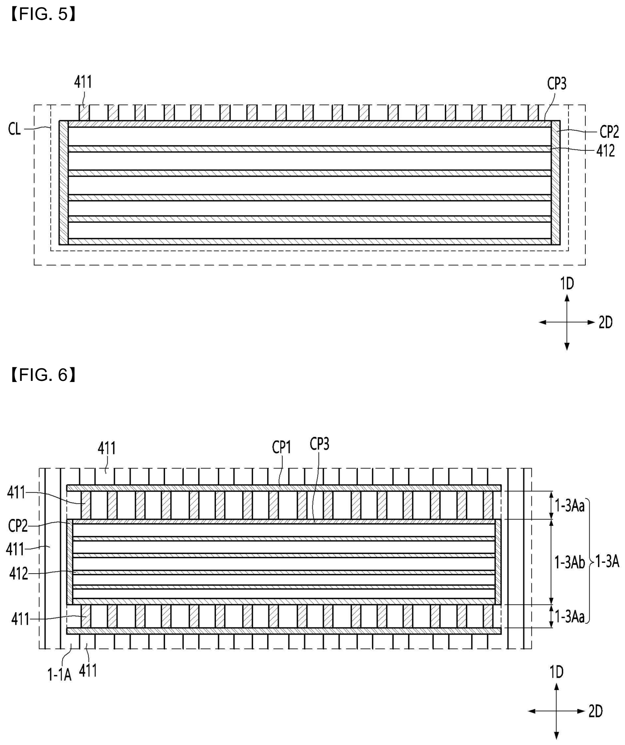

Referring to FIG. 5, the first-second pattern 412 is disposed on the first-second region 1-2A. In detail, a plurality of first-second patterns 412 are disposed on the first-second region 1-2A. The plurality of first-second patterns 412 are spaced apart in the first direction 1D.

The first-second pattern 412 has a set width. For example, a width w2 of the first-second pattern 412 may be 20 µm or less. For example, the width w2 of the first-second pattern 412 may be 5 µm to 20 µm, 6 µm to 15 µm, or 7 µm to 12 µm. Accordingly, a pattern having a fine line width is disposed on the first-second region 1-2A.

The width w1 of the first-first pattern 411 and the width w2 of the first-second pattern 412 may be different. For example, the width w2 of the first-second pattern 412 may be smaller than the width w1 of the first-first pattern 411.

A second connection pattern CP2 is disposed on the first-second region 1-2A. The second connection pattern CP2 is connected to a plurality of first-second patterns 412. In detail, the second connection pattern CP2 is connected to a plurality of first-second patterns 412 spaced apart in the first direction 1D. Therefore, the plurality of first-second patterns 412 are connected by the second connection pattern CP2.

A third connection pattern CP3 is disposed on a boundary region of the first-first region 1-1A and the first-second region 1-2A. The third connection pattern CP3 is connected to the first-first pattern 411 and the first-second pattern 412. Therefore, the first-first pattern 411 and the first-second pattern 412 are connected by the third connection pattern CP3.

Referring to FIG. 6, the first-first pattern 411 and the first-second pattern 412 are disposed on the first-third region 1-3A. In detail, a plurality of first-first patterns 411 and a plurality of first-second patterns 412 are disposed on the first-third region 1-3A.

The first-third region 1-3A may include a plurality of regions. For example, the first-third region 1-3A may include a first-third-a region 1-3Aa and a first-third-b region 1-3Ab. The first-third-a region 1-3Aa is disposed at a periphery of the first-third region 1-3A. In addition, the first-third-b region 1-3b is disposed at a center of the first-third region 1-3A. Accordingly, the first-third-b region 1-3b is disposed between the first-third-a regions 1-3Aa.

A width of the first-third-a region 1-3Aa and a width of the first-third-b region 1-3Ab may be different. For example, the width of the first-third-a region 1-3Aa may be larger than the width of the first-third-b region 1-3Ab.

The first-first pattern 411 is disposed in the first-third-a region 1-3Aa. In addition, the first-second pattern 412 is disposed in the first-third-b region 1-3Ab.

The first-third region 1-3A corresponds to the chip mounting region CHA. Accordingly, heat generated from the chip can be concentrated in the first-third region 1-3A. Accordingly, the first-first pattern 411 and the first-second pattern 412 are disposed in the first-third region 1-3A. The first-first pattern 411 and the first-second pattern 412 extend in different directions. Accordingly, heat generated in the first-third region 1-3A is dispersed in multiple directions. Accordingly, heat dissipation efficiency is improved.

The flexible circuit board is bent in a region between the chip mounting region and the fourth pad part 222b. Accordingly, the first-first pattern 411 extending in a direction in which the flexible circuit board is bent is disposed on the first-third-a region 1-3Aa. Accordingly, the flexible circuit board can be easily bent.

The first connection pattern CP1, the second connection pattern CP2, and the third connection pattern CP3 are disposed on the first-third region 1-3A. Accordingly, a plurality of first-first patterns 411 disposed on the first-third region 1-3A are connected by the first connection pattern CP1. In addition, a plurality of first-second patterns 411 disposed on the first-third region 1-3A are connected by the second connection pattern CP2. In addition, the first-first pattern 411 and the first-second pattern 411 disposed on the first-third region 1-3A are connected by the third connection pattern CP3.

A second protective layer 320 is disposed on the second surface 2S. Accordingly, the second protective layer 310 is disposed on the first-first pattern 411, the first-second pattern 412 and the connection pattern CP1, CP2, and CP3. The first protective layer 310 and the second protective layer 320 are disposed in different areas. The second protective layer 320 is also disposed on a region corresponding to the chip mounting region CHA and the pad part 212a, 212b, 222a, 222b, 232a, and 232b. Therefore, an area of the second protective layer 320 is larger than an area of the first protective layer 310.

A width of the first-first pattern 411 disposed in the first-first region 1-1A and a width of the first-first pattern 411 disposed in the first-third region 1-3A may be different. In detail, a width of the first-first pattern 411 disposed in the first-first region 1-1A may be larger than the width of the first-first pattern 411 disposed in the first-third region 1-3A.

Accordingly, a number of first-first patterns 411 disposed on the first-third region 1-3A increases. Accordingly, a path of heat generated on the first-third region 1-3A increases. Accordingly, heat dissipation efficiency is improved.

The flexible circuit board according to the first embodiment includes a metal pattern on the second surface. Accordingly, heat generated from the chip is dissipated to the outside through the metal pattern. Therefore, the internal temperature of the COF module is prevented from increasing.

In addition, the metal pattern has a set width. Accordingly, the stress is prevented from increasing due to the metal pattern. Therefore, the bending of the flexible circuit board can be prevented. That is, the warpage of the flexible circuit board is reduced.

Therefore, the flexible circuit board according to the first embodiment has improved heat dissipation characteristics and reliability.

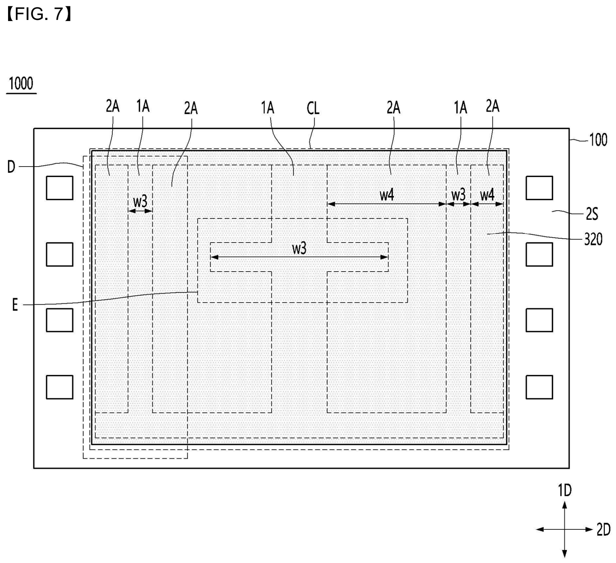

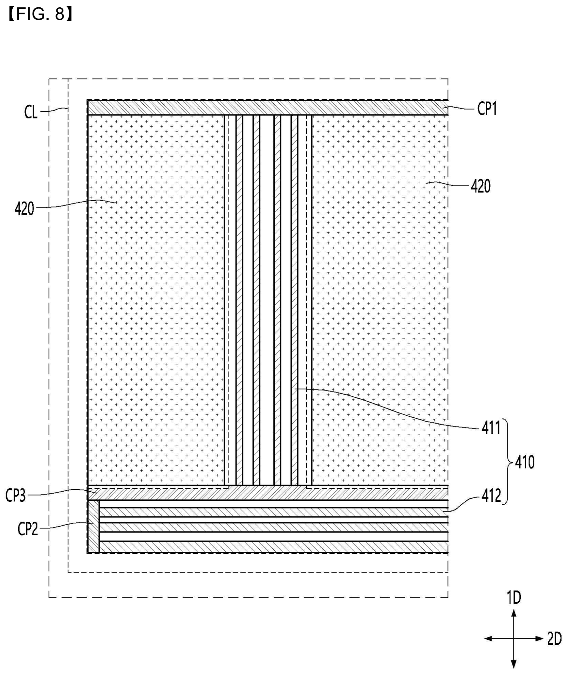

Hereinafter, a flexible circuit board according to a second embodiment will be described with reference to FIGS. 7 to 12. In FIGS. 8, 9, 11, and 12, the illustration of the second protective layer is omitted for convenience of explanation.

Referring to FIGS. 7 to 12, the metal pattern is disposed on the substrate 100. In detail, the metal pattern is disposed on the second surface 2S. The metal pattern includes a first pattern 410 and a second pattern 420.

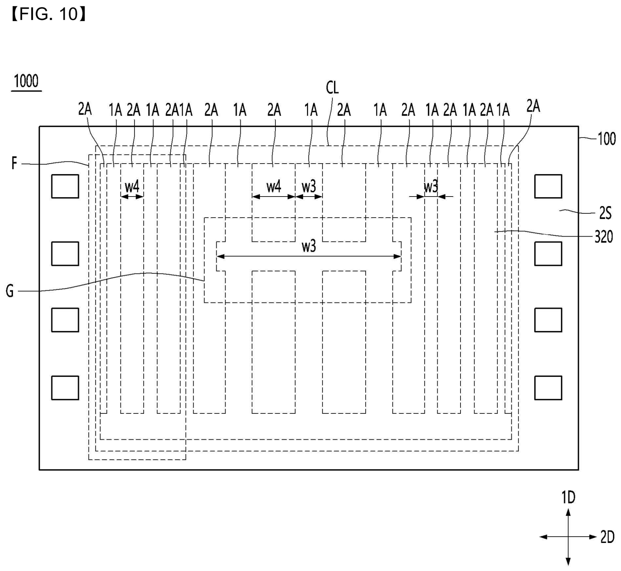

Referring to FIG. 7 and FIG. 10, the second surface 2S includes a plurality of regions. For example, the second surface 2S may include a first region 1A and a second region 2A. In detail, the second surface 2S may include a plurality of first regions 1A and a plurality of second regions 2A.

The first region 1A and the second region 2A are alternately disposed. Therefore, one second region 2A is disposed between adjacent plurality of first regions 1A. In addition, one first region 1A is disposed between adjacent plurality of second regions 2A.

One of the first regions 1A is disposed in a region corresponding to the chip mounting region CHA. For example, one of the first regions 1A may be disposed in a central region of the flexible circuit board.

The plurality of first regions 1A extend in the first direction 1D. That is, a longitudinal direction of the first regions 1A is the first direction 1D. In addition, the plurality of first regions 1A are spaced apart in the second direction 2D.

Widths w3 of the plurality of first regions 1A may be different from each other. For example, referring to FIG. 10, the widths of the plurality of first regions 1A may gradually decrease from a central region to an outer region of the flexible circuit board.

The plurality of second regions 2A are not disposed in a region corresponding to the chip mounting region CHA.

The plurality of second regions 2A extend in the first direction 1D. That is, a longitudinal direction of the second regions 2A is the first direction 1D. In addition, the plurality of second regions 2A are spaced apart from each other in the second direction 2D.

Widths w4 of the plurality of second regions 2A may be different from each other. For example, referring to FIG. 10, the width of the plurality of second regions 1A may gradually decrease from a central region to an outer region of the flexible circuit board.

Sizes of the first region 1A and the second region 2A may be different. In detail, areas of the first region 1A and the second region 2A may be different. For example, a total area of the second region 2A may be larger than a total area of the first region 1A.

Metal patterns are disposed on the first region 1A and the second region 2A, respectively. In detail, a first pattern 410 and a second pattern 420 are disposed on the first region 1A and the second region 2A.

Sizes of the first pattern 410 and the second pattern 420 are different. In detail, a width of the second pattern 420 is larger than a width of the first pattern 410. In addition, an area of the second pattern 420 is larger than an area of the first pattern 410. For example, an area of the second pattern 420 may be larger than an area of the chip mounting region CHA.

In addition, a minimum width of the second pattern 420 is larger than a minimum width of the first pattern 410.

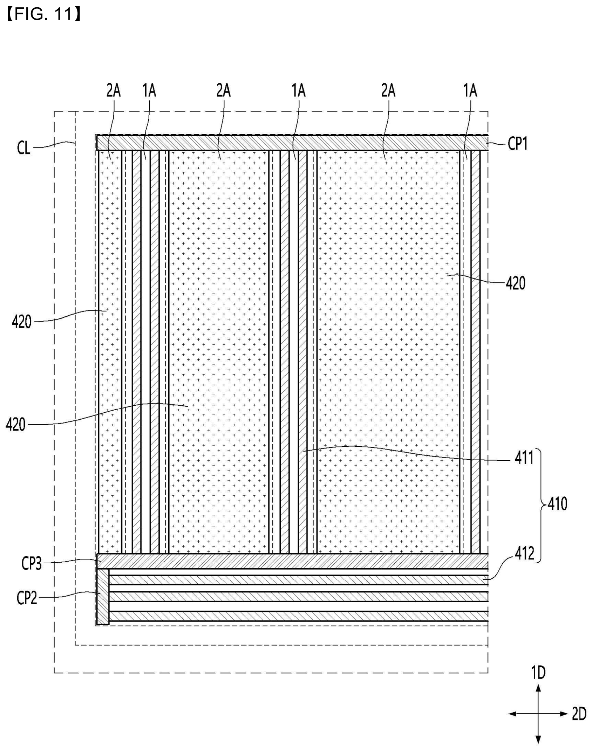

Referring to FIG. 8 and FIG. 11, the first pattern 410 is disposed on the first region 1A. The first pattern 410 has a set width. For example, the width of the first pattern 410 may be 20 µm or less. For example, the width of the first pattern 410 may be 5 µm to 20 µm, 6 µm to 15 µm, or 7 µm to 12 µm. Accordingly, a pattern having a fine line width is disposed on the first region 1A.

The first pattern 410 includes a first-first pattern 411 and a first-second pattern 412. The first-first pattern 411 and the first-second pattern 412 extend in different directions. The first-first pattern 411 extends in the first direction 1D. That is, a longitudinal direction of the first-first pattern 411 is the first direction 1D. In addition, the first-second pattern 412 extends in the second direction 2D. That is, a longitudinal direction of the first-second pattern 412 is the second direction 2D. Therefore, the first-first pattern 411 and the first-second pattern 412 extend in a longitudinal direction of the first region 1A.

A plurality of first-first patterns 411 and a plurality of first-second patterns 412 are disposed on the first region 1A. The plurality of first-first patterns 411 are spaced apart in the second direction 2D. In addition, the plurality of first-second patterns 412 are spaced apart in the first direction 1D.

A second pattern 420 is disposed on the second region 2A. An area of the second pattern 420 may be the same as or similar to an area of the second region 2A. That is, the second pattern 420 may be a bulk metal.

The metal pattern includes a plurality of connection patterns. In detail, the metal pattern includes a first connection pattern CP1, a second connection pattern CP2, and a third connection pattern CP3.

The first connection pattern CP1 is connected to a plurality of first-first patterns 411 and the second pattern 420. The plurality of first-first patterns 411 are connected by the first connection pattern CP1. In addition, the plurality of first-first patterns 411 and the second pattern 420 are connected by the first connection pattern CP1.

The second connection pattern CP2 is connected to a plurality of first-second patterns 412 and the second pattern 420. The plurality of first-second patterns 412 are connected by the second connection pattern CP2. In addition, the plurality of first-second patterns 412 and the second pattern 420 are connected by the second connection pattern CP2.

The third connection pattern CP3 is connected to the plurality of first-first patterns 412, the plurality of first-second patterns 412 and the second pattern 420. The plurality of first-first patterns 412, the plurality of first-second patterns 412 and the second pattern 420 are connected by the third connection pattern CP3.

The metal pattern has an area within a set range. The area of the metal pattern is a sum of the areas of the first pattern 410, the second pattern 420 and the connection pattern CP1, CP2, and CP3. The metal pattern may be 50% or more of an area of the active region AA. In detail, the area of the metal pattern may be 50% to 80%, 55% to 75%, or 60% to 70% of the area of the active region AA.

If the area of the metal pattern is less than 50% of the active region AA area, the heat dissipation effect by the metal pattern is reduced. Therefore, the internal temperature of the COF module increases. If the area of the metal pattern exceeds 80% of an entire area of the active region AA, the stress transmitted to the flexible circuit board increases. Therefore, the warpage of the COF module increases.

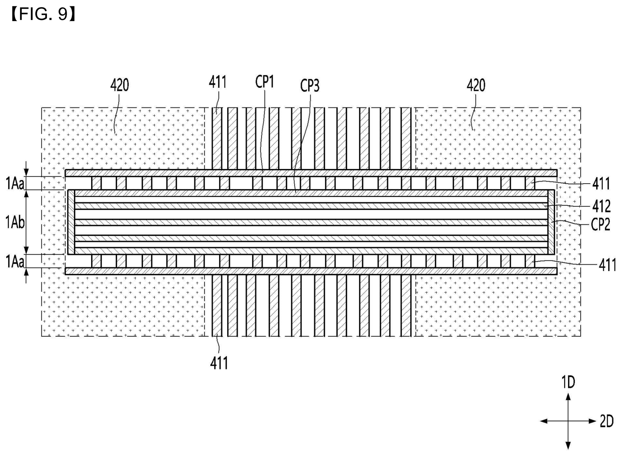

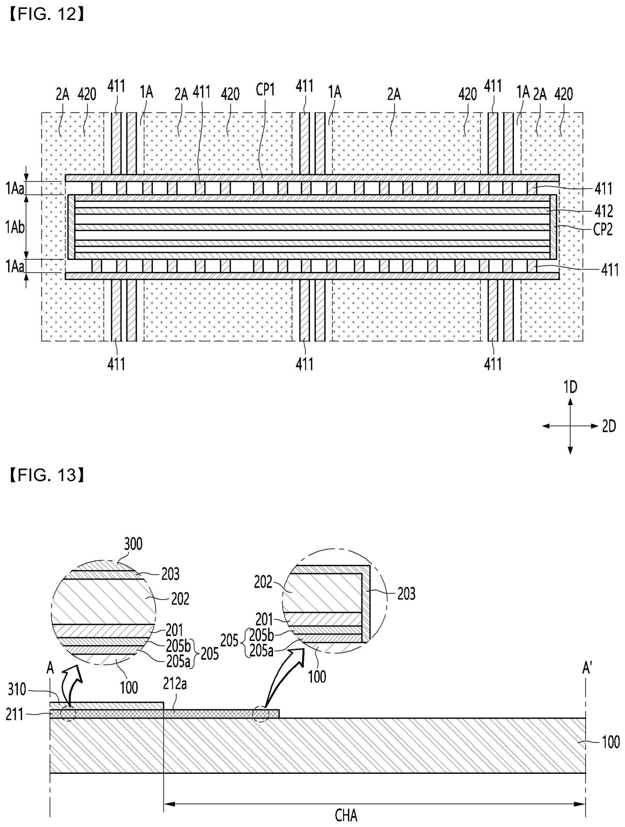

Referring to FIG. 9 and FIG. 12, one of the first regions corresponds to the chip mounting region. The first region corresponding to the chip mounting region CHA includes a plurality of regions.

For example, the first region corresponding to the chip mounting region CHA may include a first-a region 1Aa and a first-b region 1Ab. The first-a region 1Aa is disposed at a periphery of the first region corresponding to the chip mounting region CHA. In addition, the first-b region 1Ab is disposed at a center of the first region corresponding to the chip mounting region CHA. Accordingly, the first-b region 1Ab is disposed between the first-a regions 1Aa.

A width of the first-a region 1Aa and a width of the first-b region 1Ab may be different. For example, the width of the first-a region 1Aa may be larger than the width of the first-b region 1Ab.

The first-first pattern 411 is disposed on the first-a region 1Aa. In addition, the first-second pattern 412 is disposed on the first-b region 1Ab.

Therefore, heat generated from the chip can be concentrated in the first region corresponding to the chip mounting region CHA. Therefore, the first-first pattern 411 and the first-second pattern 412 extending in different directions are disposed in the first region corresponding to the chip mounting region CHA. Accordingly, heat generated in the first region corresponding to the chip mounting region CHA is dispersed in multiple directions. Therefore, heat dissipation efficiency is improved.

In addition, the flexible circuit board can be bent in a region between the chip mounting region and the fourth pad part 222b. Therefore, the first-first pattern 411 extending in a direction in which the flexible circuit board is bent is disposed on the first-a region 1Aa. Therefore, the flexible circuit board can be easily bent.

The flexible circuit board according to the second embodiment includes a metal pattern on the second surface. Therefore, heat generated from the chip is dissipated to the outside through the metal pattern. Therefore, the internal temperature of the COF module can be prevented from increasing.

In addition, the flexible circuit board includes a plurality of regions. Patterns having different areas are disposed on the plurality of regions. Therefore, the heat dissipation effect is improved by the pattern having a large area. In addition, the bending of the flexible circuit board is prevented by the pattern having a small area. In detail, the stress is prevented from increasing by the pattern having a small area. Therefore, the warpage of the flexible circuit board is reduced.

Therefore, the flexible circuit board according to the second embodiment has improved heat dissipation characteristics and reliability.

Hereinafter, the internal temperature reduction and warpage reduction according to the metal pattern are described through the flexible circuit board according to examples and comparative examples.

### Example 1

As shown in FIGS. 2 to 6 described above, a metal pattern is disposed on the second surface of the flexible circuit board. A thickness of the metal pattern is 12 µm.

Next, a chip is mounted on the flexible circuit board. Then, the flexible circuit board is cut along the cutting line. Thus, a COF module is manufactured.

Next, the internal temperature and warpage of the COF module are measured.

### Example 2

A COF module is manufactured using the flexible circuit board of FIGS. 7 to 9 described above. A thickness of the metal pattern is 8 µm.

Next, the internal temperature and warpage of the COF module are measured.

### Example 3

A COF module is manufactured using the flexible circuit board of FIGS. 10 to 12 described above. A thickness of the metal pattern is 8 µm.

Next, the internal temperature and warpage of the COF module are measured.

### Comparative Example

A metal pattern is disposed on an entire active region of the second surface of the flexible circuit board. That is, a metal pattern is disposed on an entire surface of the active region. A thickness of the metal pattern is 8 µm.

Next, the internal temperature and warpage of the COF module are measured.

**[Table 1]**

| | Internal temperature (°C) | warpage(mm) |
|---|---|---|
| Embodiment 1 | 80 | 0 |
| Embodiment 2 | 73 | 3.0 |
| Embodiment 3 | 76 | 3.0 |
| Comparative example | 76 | 4.0 |

Referring to Table 1, the warpage of the COF module according to the embodiments is 3.0mm or less. On the other hand, the warpage of the flexible circuit board according to the comparative example is 4.0mm. Therefore, the warpage of the COF module according to the embodiments is reduced.

In addition, the internal temperature of the flexible circuit board according to the embodiments 2 and 3 is 76°C or less. Therefore, the COF module according to the embodiments has improved heat dissipation characteristics.

That is, the COF module according to the embodiments has improved heat dissipation characteristics and improved warpage.

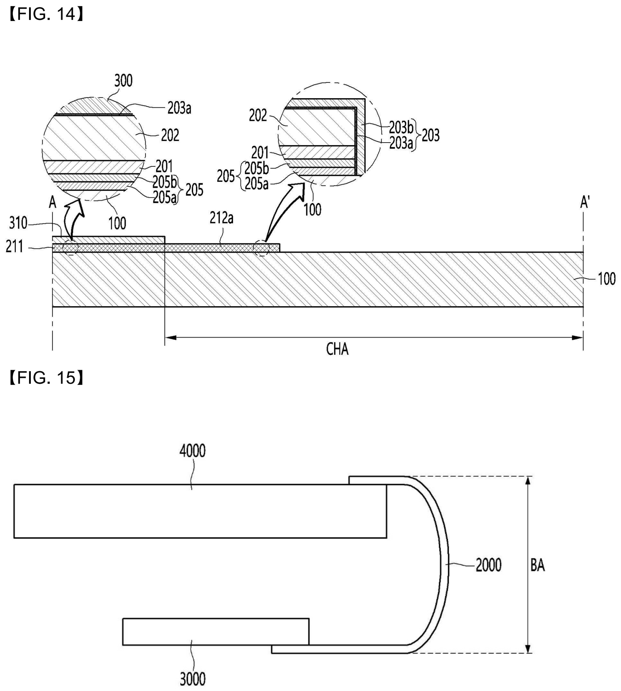

Hereinafter, referring to FIGS. 13 and 14, layer structures of the first circuit pattern, the second circuit pattern, and the third circuit pattern will be described. For convenience of explanation, a description will be based on the first circuit pattern. The following description applies to both the second circuit pattern and the third circuit pattern.

Referring to FIG. 13, the first circuit pattern is formed in multiple layers. In detail, the first circuit pattern may include a first metal layer 201 and a second metal layer 202.

The first metal layer 201 may be a seed layer of the first circuit pattern. For example, the first metal layer 201 may be a seed layer formed through electroless plating using a metal material such as copper (Cu) on the substrate 100.

The second metal layer 202 may be a plating layer. For example, the second metal layer 202 may be a plating layer formed through electrolytic plating using the first metal layer 201 as a seed layer.

A thickness of the first metal layer 201 may be smaller than a thickness of the second metal layer 202.

For example, the thickness of the first metal layer 201 may be 0.7 µm to 2 µm, and the thickness of the second metal layer 202 may be 10 µm to 25 µm.

The first metal layer 201 and the second metal layer 202 may include a same metal material. For example, the first metal layer 201 and the second metal layer 202 may include copper (Cu).

However, the embodiment is not limited thereto. For example, the first metal layer 201 and the second metal layer 202 may be formed as one metal layer.

A bonding layer 203 is disposed on the second metal layer 201. The bonding layer 203 is disposed on a side surface of the first metal layer 201, a side surface of the second metal layer 202, and an upper surface of the second metal layer 202. The bonding layer 203 is disposed to surround the first metal layer 201 and the second metal layer 202.

The bonding layer 203 may include a metal. In detail, the bonding layer 203 may include tin (Sn).

The bonding layer 203 may be formed to a thickness of 0.3 µm to 0.7 µm. A content of tin in the bonding layer 203 may increase as it extends from a lower surface to an upper surface.

The bonding layer 203 is in contact with the second metal layer 202. Therefore, a content of tin may increase and a content of copper may decrease as it extends from the lower surface to the upper surface of the bonding layer 203.

Accordingly, only pure tin can remain in a thickness of 0.1 µm to 0.3 µm from the upper surface of the bonding layer 203.

A terminal of the chip, a terminal of the circuit board, and a terminal of the display panel and the pad part are easily bonded by the bonding layer 203 through heat and pressure. When heat and pressure are applied to the pad part, an upper surface of the bonding layer melts. Pure tin remains on the upper surface of the bonding layer. Accordingly, the terminal of the chip, the terminal of the circuit board, and the terminal of the display panel are easily bonded.

The first circuit pattern may have a thickness of 2 µm to 25 µm. For example, the first circuit pattern may have a thickness of 5 µm to 20 µm. For example, the first circuit pattern may have a thickness of 7 µm to 15 µm.

If the thickness of the first circuit pattern is less than 2 µm, the resistance of the second circuit pattern increases. If the thickness of the first circuit pattern exceeds 25 µm, it becomes difficult to implement a fine pattern.

A buffer layer 205 is disposed between the substrate 100 and the first circuit pattern. The adhesion between the substrate 100 and the first circuit pattern is improved by the buffer layer 205.

The buffer layer 205 is formed in multiple layers. A first buffer layer 205a and a second buffer layer 205b on the first buffer layer 205a are disposed on the substrate 100. The first buffer layer 205a is in contact with the substrate 100. The second buffer layer 205b is in contact with the first circuit pattern 210.

The first buffer layer 205a may include a material having good adhesion to the substrate 100. For example, the first buffer layer 205a may include nickel (Ni). In addition, the second buffer layer 205b may include a material having good adhesion to the second circuit pattern. For example, the second buffer layer 205b may include chromium (Cr).

The buffer layer 205 may have a thin film thickness in nanometer units. For example, the buffer layer 205 may have a thickness of 20 nm or less.

The adhesion between the substrate 100 and the first circuit pattern is improved by the buffer layer 205. As a result, the first circuit pattern is prevented from being peeled off.

Referring to FIG. 14, the bonding layer 203 may include a plurality of bonding layers. For example, the bonding layer 203 may include a first bonding layer 203a and a second bonding layer 203b.

The first bonding layer 203a is disposed on the first wiring part 211, the first pad part 212a, and the second pad part 212b.

The second bonding layer 203b is disposed only on the first pad part 212a and the second pad part 212b. The first wiring part 211 has a different layer structure from the first pad part 212a and the second pad part 212b due to the second bonding layer 203b.

The first bonding layer 203a and the second bonding layer 203b may include metal. In detail, the first bonding layer 203a and the second bonding layer 203b may include tin (Sn).

The first bonding layer 203a and the second bonding layer 203b may be disposed with different thicknesses. In detail, the second bonding layer 203b may have a thickness greater than that of the first bonding layer 203a.

For example, the first bonding layer 203a may have a thickness of 0.02 µm to 0.06 µm, and the second bonding layer 203b may have a thickness of 0.2 µm to 0.6 µm.

If the bonding layer is thickly disposed between the protective layer 300 and the first wiring part 211, cracks may occur when the flexible circuit board is bent. Accordingly, the first bonding layer 203a between the protective layer 300 and the first wiring part 211 is formed with a thin thickness. This prevents cracks from occurring when the flexible circuit board is bent.

A chip CH is mounted on a chip mounting region CHA of the flexible circuit board according to the embodiment. Then, it is cut along the cutting line CL. As a result, a COF module is formed.

The COF module 2000 connects the display panel 4000 and the circuit board 3000.

Referring to FIG. 15, one end of the COF module 2000 is connected to the display panel 4000, and the other end is connected to the circuit board 3000. For example, the circuit board 3000 and the display panel 4000 may be disposed on one surface of the COF module 2000. However, the embodiment is not limited thereto. The display panel 4000 and the circuit board 3000 may be disposed on the other surface of the COF module 2000.

The COF module 2000 includes a flexible substrate. Therefore, the COF module 2000 may have both a rigid form and a bent form. That is, the COF module 2000 may include a bending region (BA).

The COF module 2000 can be connected between the display panel 4000 and the circuit board 3000 in a bent form. Therefore, the thickness of the electronic device is reduced. In addition, a wiring pattern of the COF module 2000 is not broken even in a bent form. Accordingly, the reliability of the electronic device including the COF module is improved.

Since the COF module is flexible, it is applied to various electronic devices.

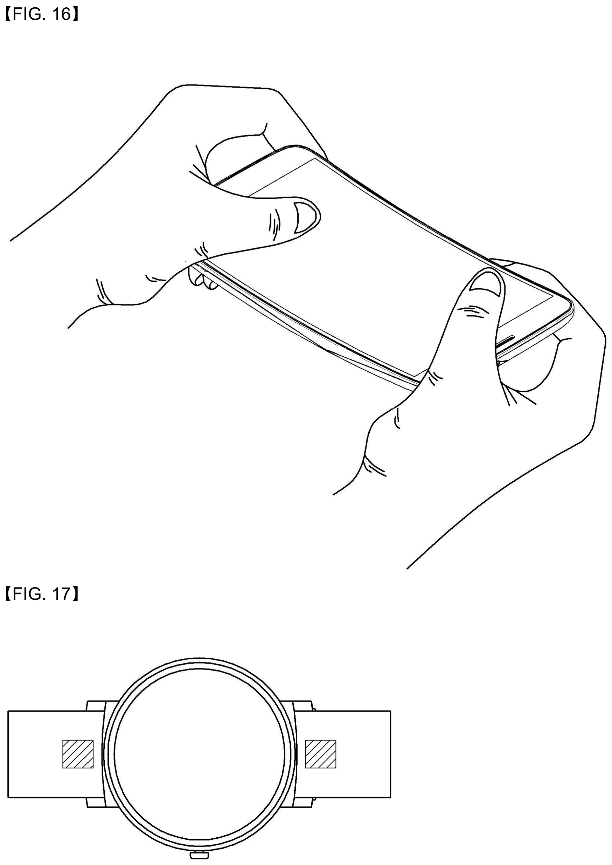

Referring to FIG. 16, the COF module is applied to a flexible touch device that bends.

Referring to FIG. 17, the COF module is applied to various wearable touch devices.

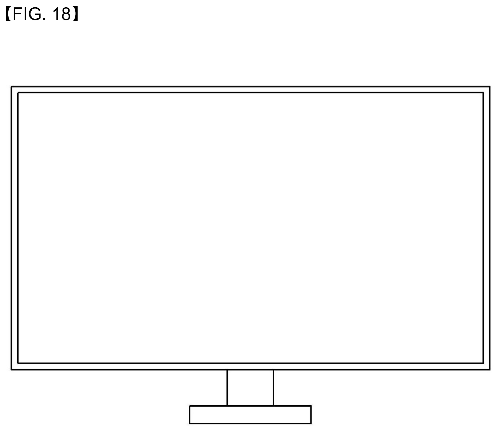

Referring to FIG. 18, the COF module is applied to electronic devices such as a TV, a monitor, or a laptop.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A flexible circuit board comprising:
a substrate including a first surface and a second surface opposite to the first surface;
a first circuit pattern and a second circuit pattern disposed on the first surface; and
a metal pattern disposed on the second surface,
wherein the second surface includes a plurality of first regions and a plurality of second regions,
wherein a first pattern is disposed on the first region,
wherein a second pattern is disposed on the second region, and
wherein an area of the second pattern is larger than an area of the first pattern.

2. The flexible circuit board of claim 1, wherein the first surface includes a chip mounting region, and
wherein the area of the second pattern is larger than an area of the chip mounting region.

3. The flexible circuit board of claim 1, wherein a width of the first pattern is 5µm to 20µm.

4. The flexible circuit board of claim 1, wherein the first pattern includes a plurality of first-first patterns and a plurality of first-second patterns extending in different directions.

5. The flexible circuit board of claim 4, wherein the first-first pattern and the first-second pattern extend in a longitudinal direction of the first region.

6. The flexible circuit board of claim 4, wherein the metal pattern includes a first connection pattern connected to the plurality of first-first patterns and the second pattern; a second connection pattern connected to the plurality of first-second patterns and the second pattern; and a third connection pattern connected to the plurality of first-first patterns, the plurality of first-second patterns, and the second pattern.

7. The flexible circuit board of claim 1, wherein the substrate defines a cutting line,
wherein the substrate includes an active region defined as an inner region of the cutting line, and
wherein an area of the metal pattern is 50% to 80% of the area of the active region.

8. The flexible circuit board of claim 4, wherein any one of the plurality of first regions corresponds to the chip mounting region,
wherein the first region corresponding to the chip mounting region includes a first-a region provided at a periphery of the first region; and a first-b region provided at a center of the first region,
wherein a width of the first-a region is larger than a width of the first-b region,
wherein the first-first pattern is disposed on the first-a region, and
wherein the first-second pattern is disposed on the first-b region.

9. A flexible circuit board comprising:
a substrate including a first surface including a chip mounting region; and a second surface opposite to the first surface;
a first circuit pattern and a second circuit pattern disposed on the first surface; and
a metal pattern disposed on the second surface,
wherein the second surface includes a first-first region, a first-second region, and a first-third region,
wherein the first-third region corresponds to the chip mounting region,
wherein the metal pattern includes a first-first pattern and a first-second pattern disposed on the first-first region, the first-second region, and the first-third region,
wherein the first-first pattern and the first-second pattern extend in different directions, and
wherein widths of the first-first pattern and the first-second pattern are 5 µm to 20 µm.

10. The flexible circuit board of claim 9, wherein a plurality of first-first patterns; and a first connection pattern connected to the plurality of first-first patterns are disposed on the first-first region.
